# EUROPEAN PATENT APPLICATION

(11) **EP 4 786 097 A1**
(43) Date of publication of application: **05.08.2026**
(21) Application number: 26154791.3
(22) Date of filing: 28.01.2026
(51) Int. Cl.: B24B 9/06, B24B 21/00, B24B 37/04, H10P 52/40, B24B 37/30, B24B 57/02, B24B 37/013, B24B 37/22

(54) **POLISHING METHOD AND POLISHING APPARATUS**

(30) Priority: 31.01.2025 JP 2025014507
(71) Applicant: EBARA CORPORATION, Ota-ku, Tokyo 144-8510 (JP)
(72) Inventor: SATAKE, Masayuki, Tokyo, 1448510 (JP); UCHIYAMA, Keisuke, Tokyo, 1448510 (JP); YAMAMOTO, Satoru, Tokyo, 1448510 (JP); NAKANISHI, Masayuki, Tokyo, 1448510 (JP)
(74) Representative: Wagner & Geyer

(57) **Abstract**

A polishing method capable of improving flatness of a bonding surface for forming a laminated substrate is disclosed. The polishing method includes: measuring a shape of a periphery of a substrate having the bonding surface for forming the laminated substrate, the bonding surface including a surface of a device region and a surface of a dielectric film formed on the periphery and raised from the device region; determining a polishing recipe including a change in a movement speed of a polishing head from a polishing start position to a polishing end position based on the measured shape of the periphery; and polishing the dielectric film to planarize the bonding surface by pressing, by the polishing head, a polishing tool against the periphery of the substrate being rotated while the polishing head is moved in a radial direction of the substrate according to the determined polishing recipe.

## Description

### BACKGROUND OF THE INVENTION

### Field of the Invention:

The present invention relates to a polishing method and a polishing apparatus for polishing a periphery of a substrate, such as a wafer, before being bonded as a laminated substrate.

### Description of the Related Art:

In recent years, in order to achieve higher density and higher functionality in semiconductor devices, three-dimensional packaging technology, in which substrates are laminated and integrated three-dimensionally, has been developed. For example, in the three-dimensional packaging technology, a device surface of a first substrate on which integrated circuits and electrical wires are formed is bonded to a device surface of a second substrate on which integrated circuits and electrical wires are formed. After the first substrate is bonded to the second substrate, the first substrate is thinned by a polishing apparatus or a grinding apparatus. In this manner, integrated circuits can be stacked in a direction perpendicular to the device surfaces of the first substrate and the second substrate.

### Citation List

### Patent Literature

Patent document 1: Japanese laid-open patent publication No. 2011-224680

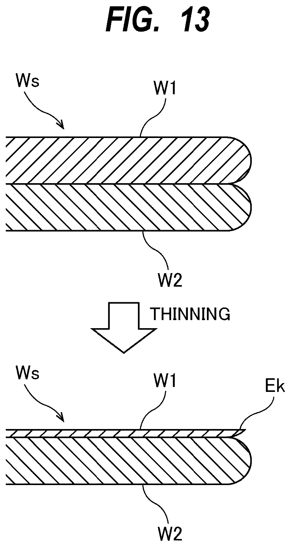

FIG. 13 is a diagram illustrating a knife-edge portion Ek formed by thinning a first substrate W1 of a laminated substrate Ws. The laminated substrate Ws shown in FIG. 13 is produced by bonding a second substrate W2 to the first substrate W1. Generally, peripheries of the first substrate W1 and the second substrate W2 are polished in advance to each have a rounded shape or a beveled shape in order to prevent cracking or chipping of the peripheries. When the first substrate W1 having such a shape is thinned, an acute edge Ek is formed in the first substrate W1 as a result of thinning. This acute edge (hereinafter referred to as a knife-edge portion) Ek is constituted of a grinded back surface and a circumferential surface of the first substrate W1. Such a knife-edge portion Ek is likely to be chipped by a physical contact, and the laminated substrate Ws itself may be broken during transportation of the laminated substrate Ws.

Thus, as one method for preventing cracking or chipping of the knife-edge portion Ek, a dielectric film may be formed on the periphery of the first substrate W1 and the periphery of the second substrate W2 before the first substrate W1 is bonded to the second substrate W2. In the laminated substrate Ws composed of the first substrate W1 and the second substrate W2 having the dielectric film formed on the periphery, the knife-edge portion Ek formed after thinning of the first substrate W1 is supported by the dielectric film, so that cracking or chipping of the knife-edge portion Ek can be prevented.

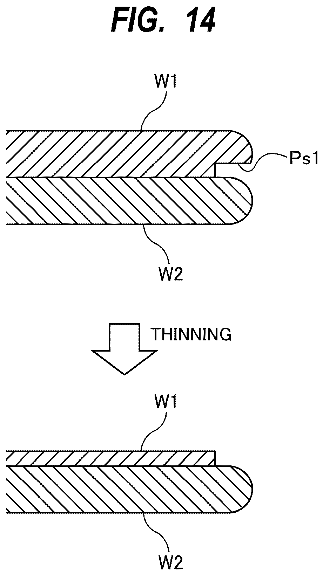

Further, as another method for preventing cracking or chipping of the knife-edge portion Ek, as shown in FIG. 14, the first substrate W1 is bonded to the second substrate W2 after a part of the periphery of the first substrate W1 is trimmed. A step portion Ps1 is formed in the trimmed periphery of the first substrate W1. In the laminated substrate Ws produced in this manner, the knife-edge portion Ek is not formed after thinning of the first substrate W1. In this case, in order to fill a gap between the step portion Ps1 of the bonded first substrate W1 and the periphery of the bonded second substrate W2, a dielectric film may be each formed on the step portion Ps1 of the first substrate W1 and the periphery of the second substrate W2 before the first substrate W1 is bonded to the second substrate W2.

However, if the first substrate is bonded to the second substrate in a state where flatness of the bonding surface of each substrate on which the dielectric film is formed is low, a gap may be generated between the device surface of the first substrate and the device surface of the second substrate, so that a bonding failure may occur.

### SUMMARY OF THE INVENTION

Therefore, the present invention provides a polishing method and a polishing apparatus capable of improving flatness of a bonding surface for forming a laminated substrate.

In an embodiment, there is provided a polishing method comprising: measuring a shape of a periphery of a substrate having a bonding surface for forming a laminated substrate, the bonding surface including a surface of a device region and a surface of a dielectric film formed on the periphery and raised from the device region; determining a polishing recipe including a change in a movement speed of a polishing head from a polishing start position to a polishing end position based on the measured shape of the periphery; and polishing the dielectric film to planarize the bonding surface by pressing, by the polishing head, a polishing tool against the periphery of the substrate being rotated while the polishing head is moved in a radial direction of the substrate according to the determined polishing recipe.

In an embodiment, the movement speed of the polishing head at a portion where a film thickness of the dielectric film is large is lower than the movement speed of the polishing head at a portion where the film thickness of the dielectric film is small.

In an embodiment, the polishing tool comprises a polishing tape having abrasive grains, and the abrasive grains comprise ceria abrasive grains.

In an embodiment, the polishing of the dielectric film is performed without supplying liquid to the bonding surface.

In an embodiment, the polishing of the dielectric film is performed while supplying liquid from a liquid supply nozzle to the bonding surface.

In an embodiment, the polishing method further comprises: measuring the shape of the periphery after the polishing of the dielectric film; judging necessity of re-polishing of the dielectric film based on the measured shape of the periphery after polishing; determining a re-polishing target region which is a portion of the periphery having a height larger than a height of the surface of the device region when judging that the re-polishing of the dielectric film is necessary; and polishing the re-polishing target region by pressing, by the polishing head, the polishing tool against the re-polishing target region of the substrate being rotated.

In an embodiment, the polishing method further comprises: measuring a height of a polished portion of the dielectric film by a height measuring device during the polishing of the dielectric film; and limiting movement of the polishing head based on the height of the polished portion of the dielectric film.

In an embodiment, the height measuring device is attached to the polishing head.

In an embodiment, the height measuring device is arranged away from the polishing head, and is arranged at the same position as the polishing head in the radial direction of the substrate.

In an embodiment, there is provided a polishing apparatus comprising: a substrate holder configured to hold and rotate a substrate having a bonding surface for forming a laminated substrate; a polishing head configured to press a polishing tool against a periphery of the substrate; a polishing-head moving mechanism configured to move the polishing head in a radial direction of the substrate held by the substrate holder; and an operation controller configured to control operations of the polishing head and the polishing-head moving mechanism, wherein the bonding surface includes a surface of a device region and a surface of a dielectric film formed on the periphery and raised from the device region, the operation controller is configured to: determine a polishing recipe including a change in a movement speed of the polishing head from a polishing start position to a polishing end position based on a shape of the periphery measured in advance; and instruct the polishing head and the polishing-head moving mechanism to press the polishing tool against the periphery of the substrate being rotated while causing the polishing head to be moved according to the determined polishing recipe, thereby polishing the dielectric film to planarize the bonding surface.

In an embodiment, the movement speed of the polishing head at a portion where a film thickness of the dielectric film is large is lower than the movement speed of the polishing head at a portion where the film thickness of the dielectric film is small.

In an embodiment, the polishing tool comprises a polishing tape having abrasive grains, and the abrasive grains comprise ceria abrasive grains.

In an embodiment, the polishing apparatus is configured to polish the dielectric film without supplying liquid to the bonding surface.

In an embodiment, the polishing apparatus further comprises: a liquid supply nozzle configured to supply liquid to the bonding surface, wherein the operation controller is configured to instruct the liquid supply nozzle to supply the liquid to the bonding surface during polishing of the dielectric film.

In an embodiment, the operation controller is configured to: judge necessity of re-polishing of the dielectric film based on the shape of the periphery measured after polishing of the dielectric film; determine a re-polishing target region which is a portion of the periphery having a height larger than a height of the surface of the device region when judging that the re-polishing of the dielectric film is necessary; and instruct the polishing head to polish the re-polishing target region by causing the polishing head to press the polishing tool against the re-polishing target region of the rotating substrate.

In an embodiment, the polishing apparatus further comprises: a height measuring device configured to measure a height of a polished portion of the dielectric film during polishing of the dielectric film, wherein the operation controller is configured to limit movement of the polishing head based on the height of the polished portion of the dielectric film.

In an embodiment, the height measuring device is attached to the polishing head.

In an embodiment, the height measuring device is arranged away from the polishing head, and is arranged at the same position as the polishing head in the radial direction of the substrate held by the substrate holder.

The polishing recipe including the change in the movement speed of the polishing head from the polishing start position to the polishing end position is determined based on the shape of the periphery of the substrate measured in advance, and the dielectric film formed on the periphery of the substrate is polished according to the determined polishing recipe. Therefore, the dielectric film is polished with an appropriate polishing recipe according to the shape of the periphery, so that flatness of the bonding surface for forming the laminated substrate can be improved.

### BRIEF DESCRIPTION OF THE DRAWINGS

FIG. 1 is a schematic diagram showing an embodiment of a method of producing a laminated substrate;
FIG. 2 is a schematic diagram showing another embodiment of the method of producing the laminated substrate;
FIG. 3 is a side view showing an embodiment of a polishing apparatus for planarizing a first surface of a first substrate;
FIG. 4 is a front view of a pressing member shown in FIG. 3;
FIG. 5 is a schematic diagram illustrating a manner in which a polishing head polishes a dielectric film of the first substrate;
FIG. 6 is a cross-sectional view showing an example of a periphery of the first substrate;
FIG. 7 is a schematic diagram illustrating a manner in which a shape of the periphery of the first substrate is measured before polishing of the dielectric film of the first substrate;
FIG. 8 is a graph showing a measurement result of the shape of the periphery of the first substrate shown in FIG. 6 measured by a shape measuring device;
FIGS. 9A and 9B are graphs each showing an example of a change in movement speed of the polishing head from a polishing start position to a polishing end position, as determined by an operation controller;
FIG. 10 is a schematic diagram showing an embodiment of a height measuring device configured to measure the shape of the periphery of the first substrate during polishing of the dielectric film of the first substrate;
FIG. 11 is a plan view showing another embodiment of the height measuring device;
FIG. 12 is a plan view showing another embodiment of the polishing apparatus;
FIG. 13 is a diagram illustrating a knife-edge portion formed by thinning a first substrate of a laminated substrate; and
FIG. 14 is a diagram illustrating a manner of thinning the first substrate of the laminated substrate constituted of the first substrate that has been trimmed at a part of the periphery and a second substrate.

### DESCRIPTION OF EMBODIMENTS

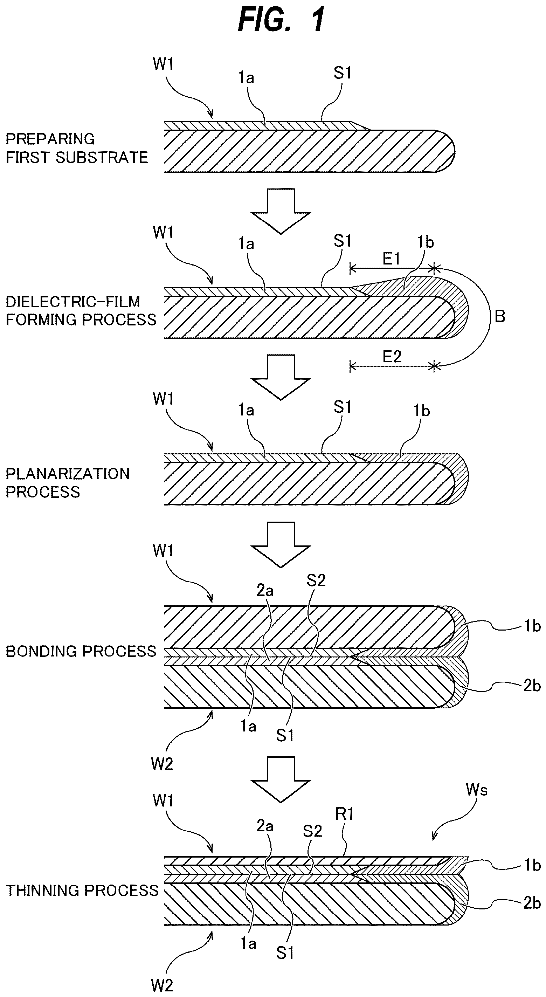

Hereinafter, an embodiment of the present invention will be described with reference to the drawings. FIG. 1 is a schematic diagram showing an embodiment of a method of producing a laminated substrate Ws. As shown in FIG. 1, first, a first substrate W1 is prepared. An example of the first substrate W1 is a wafer used for semiconductor devices. The first substrate W1 has a bonding surface S1 for forming the laminated substrate Ws. The bonding surface S1 includes a surface of a device region 1a where devices are formed.

Next, a dielectric-film forming process of forming a dielectric film 1b on a periphery of the first substrate W1 is performed. The dielectric film 1b is formed on the periphery of the first substrate W1 located outside the device region 1a by a vapor deposition method or the like. Examples of the dielectric film 1b include an oxide film and a nitride film. The dielectric film 1b is formed so as to cover the periphery of the first substrate W1 where no device is formed and so as to be raised from the device region 1a. In one embodiment, a portion of the dielectric film 1b raised from the device region 1a has a height of 1 nm to 50 µm from the surface of the device region 1a. A part of the dielectric film 1b may be formed on the device region 1a.

The periphery of the first substrate W1 is polished in advance to have a rounded shape or a beveled shape in order to prevent cracking or chipping of the periphery. The periphery of the first substrate W1 is constituted of a bevel portion B constituting an outermost circumferential surface of the first substrate W1 and having a curved cross section or a beveled shape, a top edge portion E1 which is a region located radially inwardly of the bevel portion B and is a flat portion located radially outwardly of the surface of the device region 1a, and a bottom edge portion E2 which is a flat portion located at an opposite side from the top edge portion E1 and is located radially inwardly of the bevel portion B.

The dielectric film 1b is formed on the top edge portion E1 and the bevel portion B of the periphery of the first substrate W1. An outer end portion of the dielectric film 1b in a radial direction is located outwardly of an outer end portion of the first substrate W1 in the radial direction. In one embodiment, a width from an inner end portion to the outer end portion of the dielectric film 1b in the radial direction is 0.1 mm to 10 mm. In the first substrate W1 on which the dielectric film 1b is formed, the bonding surface S1 includes the surface of the device region 1a and a surface of the dielectric film 1b.

Next, a planarization process of polishing the dielectric film 1b to planarize the bonding surface S1 is performed. In the planarization process, the portion of the dielectric film 1b raised from the device region 1a is polished, so that a height of the dielectric film 1b has the same height as the device region 1a. Specifically, the dielectric film 1b is polished, so that the surface of the dielectric film 1b and the surface of the device region 1a are located in the same plane to planarize the bonding surface S1.

Next, a bonding process of bonding the first substrate W1, having the planarized bonding surface S1, to a second substrate W2 is performed. The second substrate W2 may be prepared in advance, prepared after the planarization process of the first substrate W1 is completed, or prepared simultaneously with the first substrate W1. In this embodiment, the second substrate W2 has the same configuration as the first substrate W1. In another embodiment, the second substrate W2 may have a configuration different from that of the first substrate W1. The second substrate W2 has a bonding surface S2 for forming the laminated substrate Ws. The bonding surface S2 includes a surface of a device region 2a where devices are formed, and a surface of a dielectric film 2b.

In one embodiment, the second substrate W2 is produced in the same manner as the first substrate W1. Specifically, the dielectric film 2b raised from the device region 2a is formed on a periphery of the second substrate W2, and the dielectric film 2b is then polished to planarize the bonding surface S2 of the second substrate W2.

The bonding surface S1 of the first substrate W1 is bonded to the bonding surface S2 of the second substrate W2. The device region 1a of the first substrate W1 faces the device region 2a of the second substrate W2 and is in contact with the device region 2a. The dielectric film 1b of the first substrate W1 faces the dielectric film 2b of the second substrate W2 and is in contact with the dielectric film 2b. Bonding of the first substrate W1 and the second substrate W2 is performed using a known technique, such as hybrid bonding or fusion bonding.

Next, a thinning process of grinding a non-bonding surface R1 of the first substrate W1 opposite to the bonding surface S1 is performed. In this thinning process, a part of the dielectric film 1b formed on the non-bonding surface R1 and the bevel portion B is ground by a thinning device (not shown), such as a grinding apparatus, so that a thickness of the first substrate W1 is reduced. In this manner, the laminated substrate Ws having the second substrate W2 bonded to the first substrate W1 is produced. The dielectric film 1b and the dielectric film 2b can support a knife-edge portion formed after the thinning process of the first substrate W1. Therefore, the dielectric film 1b and the dielectric film 2b can prevent cracking and chipping of the laminated substrate Ws.

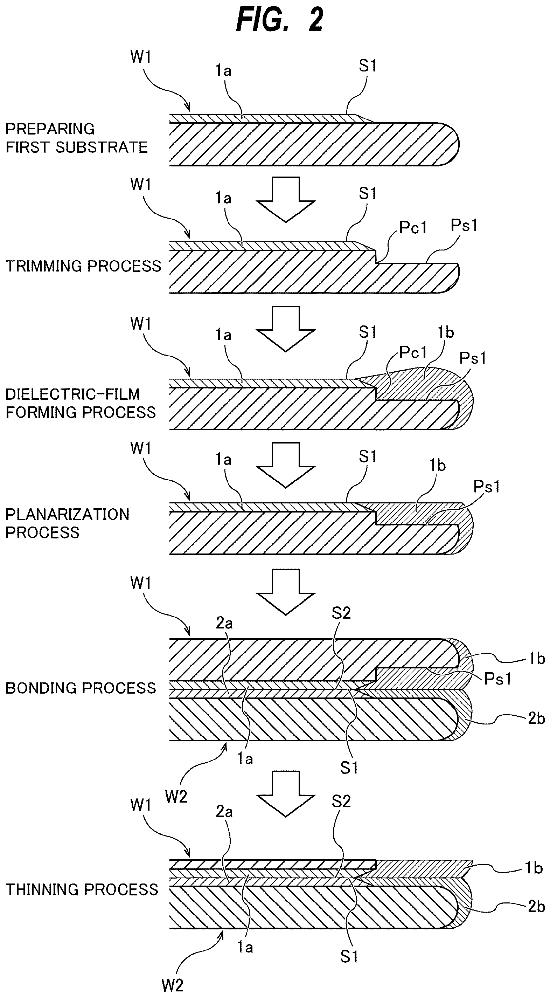

FIG. 2 is a schematic diagram showing another embodiment of the method of producing the laminated substrate Ws. In the embodiment shown in FIG. 2, after the first substrate W1 is prepared, a trimming process of forming a step portion Ps1 in the periphery of the first substrate W1 located outside the device region 1a is performed. The step portion Ps1 has an annular shape extending in a circumferential direction of the first substrate W1. The step portion Ps1 has an inner corner portion Pc1. In one embodiment, the inner corner portion Pc1 has a right-angled shape. In one embodiment, a width of the step portion Ps1 in a radial direction is in a range of 5 mm to 10 mm.

Next, a dielectric-film forming process of forming a dielectric film 1b on the step portion Ps1 of the first substrate W1 is performed. The dielectric film 1b is formed on the step portion Ps1 so as to be raised from the device region 1a. The dielectric film 1b is formed on the entire step portion Ps1 including the inner corner portion Pc1. In one embodiment, a portion of the dielectric film 1b raised from the device region 1a has a height of 1 nm to 20 µm from the surface of the device region 1a. The dielectric film 1b may extend slightly beyond the step portion Ps1. For example, a part of the dielectric film 1b may be formed on the device region 1a. An outer end portion of the dielectric film 1b in the radial direction is located outwardly of an outer end portion of the first substrate W1 in the radial direction.

The planarization process, the bonding process, and the thinning process are the same as those of the embodiment described with reference to FIG. 1. In one embodiment, the second substrate W2 is produced in the same manner as the embodiment described with reference to FIG. 1. Specifically, the dielectric film 2b raised from the device region 2a is formed on a periphery of the second substrate W2, and the dielectric film 2b is then polished to planarize the bonding surface S2 of the second substrate W2. In one embodiment, the second substrate W2 may be produced in the same manner as the first substrate W1. Specifically, a step portion is formed in the periphery of the second substrate W2, the dielectric film 2b raised from the device region 2a of the second substrate W2 is formed on the step portion of the second substrate W2, and the dielectric film 2b is then polished to planarize the bonding surface S2 of the second substrate W2.

In the embodiment shown in FIG. 2, since a portion that can be a knife-edge portion of the periphery of the first substrate W1 is trimmed, cracking and chipping of the laminated substrate Ws can be prevented. Further, since the dielectric film 1b and the dielectric film 2b are formed on the step portion Ps1 of the first substrate W1 and the periphery of the second substrate W2, the first substrate W1 and the second substrate W2 can be bonded without a gap.

In the bonding process shown in FIGS. 1 and 2, if the first substrate W1 is bonded to the second substrate W2 with a bonding surface S1 of the first substrate W1 and a bonding surface S2 of the second substrate W2 having low flatness, a gap may be formed between the device region 1a of the first substrate W1 and the device region 2a of the second substrate W2, and as a result a bonding failure may occur. Therefore, a polishing apparatus 100 described below for use in the planarization process is configured to planarize the bonding surface S1 of the first substrate W1 and the bonding surface S2 of the second substrate W2 with high accuracy.

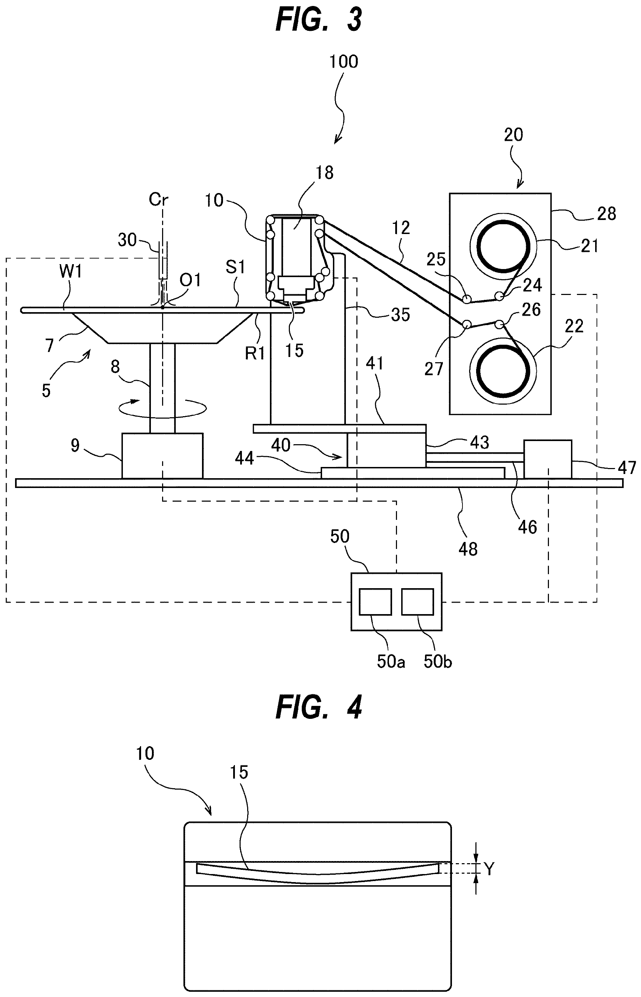

FIG. 3 is a side view showing an embodiment of the polishing apparatus 100. Hereinafter, a case where the polishing apparatus 100 performs planarization of the bonding surface S1 of the first substrate W1 will be described, while planarization of the bonding surface S2 of the second substrate W2 is performed in the same manner by the polishing apparatus 100. The polishing apparatus 100 includes a substrate holder 5 configured to hold and rotate the first substrate W1, a polishing head 10 configured to press a polishing tape 12 as a polishing tool against the periphery of the first substrate W1, a polishing-tape feeding mechanism 20 configured to feed the polishing tape 12 to the polishing head 10 and collect the polishing tape 12 from the polishing head 10, and a liquid supply nozzle 30 configured to supply liquid onto the bonding surface S1 of the first substrate W1.

The substrate holder 5 includes a holding stage 7 configured to hold the first substrate W1 by vacuum suction, a shaft 8 coupled to a center portion of the holding stage 7, and a holding-stage driving mechanism 9 configured to rotate and vertically move the holding stage 7. The holding-stage driving mechanism 9 is configured to be able to rotate the holding stage 7 about a predetermined rotation axis Cr, and vertically move the holding stage 7 along the predetermined rotation axis Cr. An axis extending through the center O1 of the first substrate W1 and the predetermined rotation axis Cr substantially coincide with each other. The holding-stage driving mechanism 9 includes an electric motor (not shown).

The polishing head 10 is configured to press the polishing tape 12 against the periphery of the first substrate W1 to polish the periphery of the first substrate W1. The polishing head 10 includes a pressing member 15 configured to press a polishing surface of the polishing tape 12 against the periphery of the first substrate W1, and a pressing actuator 18 configured to apply a pressing force to the pressing member 15. The pressing actuator 18 is coupled to the pressing member 15, and is configured to move the pressing member 15 in a direction toward and a direction away from the periphery of the first substrate W1 on the holding stage 7. The specific configuration of the pressing actuator 18 is not particularly limited. The pressing actuator 18 is constituted by an air cylinder or an electric linear actuator. The pressing member 15 is arranged at a back side of the polishing tape 12 (at a back side of the polishing surface having abrasive grains). The pressing member 15 is moved toward the first substrate W1 by the pressing actuator 18 to thereby press the polishing tape 12 against the periphery of the first substrate W1 from the back side of the polishing tape 12. In this manner, the polishing head 10 polishes the periphery of the first substrate W1.

The polishing tape 12 of this embodiment has ceria (CeO₂) abrasive grains on the polishing surface of the polishing tape 12. The ceria abrasive grains have good polishing properties for the dielectric film 1b, such as an oxide film or a nitride film. Specifically, the polishing tape 12 having the ceria abrasive grains can polish the dielectric film 1b with high flatness without causing polishing scratches on the surface of the dielectric film 1b. In another embodiment, the polishing tape 12 may have other abrasive grains, such as diamond abrasive grains, on the polishing surface of the polishing tape 12.

In one embodiment, the polishing tool may be a whetstone fixed to the pressing member 15 instead of the polishing tape 12. The whetstone has abrasive grains, such as ceria abrasive grains or diamond abrasive grains, on the polishing surface of the whetstone.

FIG. 4 is a front view of the pressing member 15 shown in FIG. 3. The pressing member 15 has a curved shape along the circumferential direction of the first substrate W1 when viewed from a front side. More specifically, the pressing member 15 has an arc shape having substantially the same curvature as a curvature of the first substrate W1. A width Y of the pressing member 15 shown in FIG. 4 is smaller than a width of the dielectric film 1b of the first substrate W1 in the radial direction. As an example, the pressing member 15 is made of resin, such as PEEK (polyether ether ketone).

As shown in FIG. 3, the polishing-tape feeding mechanism 20 includes a tape feeding reel 21, a tape take-up reel 22, and a plurality of guide rollers 24, 25, 26, and 27. The tape feeding reel 21, the tape take-up reel 22, and the plurality of guide rollers 24, 25, 26, and 27 are fixed to a reel base 28. The polishing tape 12 is supplied to the polishing head 10 such that a polishing surface of the polishing tape 12 faces the periphery of the first substrate W1. An advancing direction of the polishing tape 12 is guided by the guide rollers 24, 25, 26, and 27.

Not-shown tension motors are coupled to the tape feeding reel 21 and the tape take-up reel 22, respectively. The tape feeding reel 21 and the tape take-up reel 22 are fixed to the reel base 28 via the tension motors. The tension motors are configured to apply a predetermined torque to the tape feeding reel 21 and the tape take-up reel 22, respectively, so that a predetermined tension can be generated in the polishing tape 12.

The liquid supply nozzle 30 is configured to supply the liquid onto the bonding surface S1. In one embodiment, the polishing apparatus 100 may further include a liquid supply nozzle configured to supply liquid onto the non-bonding surface R1. Examples of the liquid supplied to the first substrate W1 include pure water, chemical liquid, and the like. In this embodiment, the liquid is supplied from the liquid supply nozzle 30 to the bonding surface S1 during polishing of the first substrate W1.

The polishing apparatus 100 further includes a polishing-head moving mechanism 40 configured to move the polishing head 10 in the radial direction of the first substrate W1 held by the substrate holder 5. The polishing-head moving mechanism 40 includes a coupling member 43, a guide rail 44, a coupling shaft 46, and a linear actuator 47. The polishing-head moving mechanism 40 is coupled to the polishing head 10 via a movable plate 41. More specifically, a polishing-head support member 35 coupled to the polishing head 10 is coupled to an upper surface of the movable plate 41, and the polishing-head moving mechanism 40 is coupled to a lower surface of the movable plate 41. The polishing head 10 is movable integrally with the movable plate 41.

The guide rail 44 extends parallel to a line connecting the polishing head 10 and the predetermined rotation axis Cr on the holding stage 7 (i.e., the center O1 of the first substrate W1) when viewed from above. The guide rail 44 is fixed to a base plate 48. The linear actuator 47 is coupled to the movable plate 41 via the coupling member 43 and the coupling shaft 46, and is fixed to the base plate 48. The linear actuator 47 is driven to move the movable plate 41 along the guide rail 44, so that the polishing-head moving mechanism 40 can move the polishing head 10 in a direction toward the predetermined rotation axis Cr of the first substrate W1 (i.e., the center O1 of the first substrate W1) and in a direction away from the predetermined rotation axis Cr (i.e., the center O1 of the first substrate W1). Examples of the linear actuator 47 include a servomotor, a stepping motor, and the like. The linear actuator 47 is configured to be able to control a position of the polishing head 10 in the radial direction with respect to the first substrate W1 and a movement speed of the polishing head 10 based on a rotation speed of the linear actuator 47.

The specific configuration of the polishing-head moving mechanism 40 is not limited to this embodiment as long as the polishing head 10 can be moved in the direction toward the predetermined rotation axis Cr of the first substrate W1 (i.e., the center O1 of the first substrate W1) and in the direction away from the predetermined rotation axis Cr (i.e., the center O1 of the first substrate W1).

The polishing apparatus 100 further includes an operation controller 50 configured to control operations of the polishing apparatus 100. The substrate holder 5, the polishing head 10, the polishing-tape feeding mechanism 20, the liquid supply nozzle 30, and the polishing-head moving mechanism 40 are electrically coupled to the operation controller 50. Operations of the substrate holder 5, the polishing head 10, the polishing-tape feeding mechanism 20, the liquid supply nozzle 30, and the polishing-head moving mechanism 40 are controlled by the operation controller 50.

The operation controller 50 includes at least one computer. The operation controller 50 includes a memory 50a storing programs therein, and an arithmetic device 50b configured to perform arithmetic operations according to instructions contained in the programs. The memory 50a includes a main memory (e.g., a random access memory) to which the arithmetic device 50b is accessible, and an auxiliary memory (e.g., a hard disk drive or a solid state drive) configured to store the programs. The arithmetic device 50b includes a CPU (central processing unit) or a GPU (graphic processing module) configured to perform arithmetic operations according to the instructions contained in the programs stored in the memory 50a. However, the specific configuration of the operation controller 50 is not limited to these examples.

Polishing of the dielectric film 1b of the first substrate W1 is performed as follows. The first substrate W1, with its bonding surface S1 facing upward, is placed on a substrate holding surface of the holding stage 7, and is held by vacuum suction. The operation controller 50 instructs the holding-stage driving mechanism 9 of the substrate holder 5 to rotate the first substrate W1 and the holding stage 7. Further, the operation controller 50 instructs the liquid supply nozzle 30 to supply the liquid from the liquid supply nozzle 30 onto the bonding surface S1 of the first substrate W1.

Next, the operation controller 50 instructs the polishing-tape feeding mechanism 20 to advance the polishing tape 12 from the tape feeding reel 21 to the tape take-up reel 22 via the pressing member 15 of the polishing head 10 at a predetermined speed. Thereafter, the operation controller 50 instructs the pressing actuator 18 of the polishing head 10 to press the polishing tape 12 against the periphery of the first substrate W1 with the pressing member 15 of the polishing head 10. In this manner, the dielectric film 1b formed on the periphery of the first substrate W1 is polished.

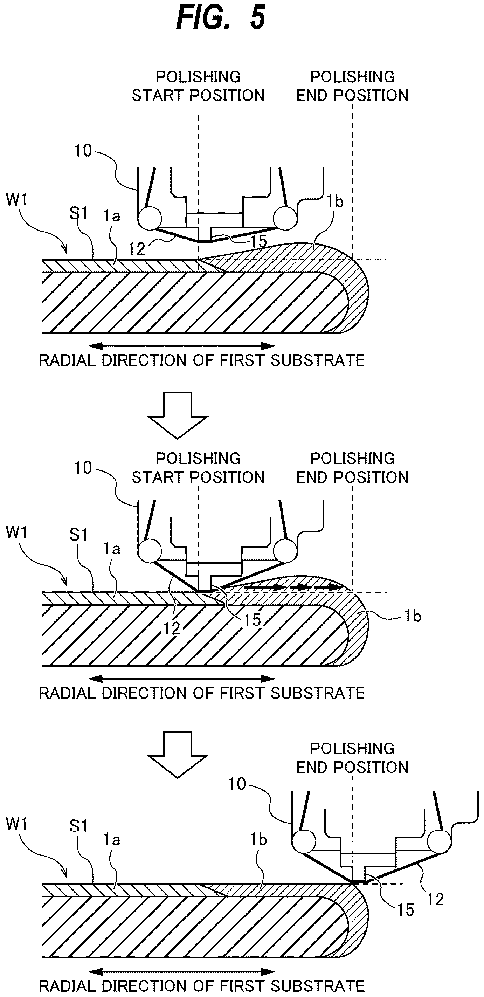

FIG. 5 is a schematic diagram illustrating a manner in which the polishing head 10 polishes the dielectric film 1b of the first substrate W1. The polishing head 10 polishes a region from a polishing start position to a polishing end position of the dielectric film 1b. The polishing start position is the inner end portion of the surface of the dielectric film 1b in the radial direction, and is located at a boundary between the surface of the device region 1a and the surface of the dielectric film 1b. The polishing end position is the outer end portion of the dielectric film 1b in the radial direction at the same height as the surface of the device region 1a. The region from the polishing start position to the polishing end position of the dielectric film 1b is raised from the device region 1a. The dielectric film 1b is polished with the polishing head 10, so that the surface of the dielectric film 1b and the surface of the device region 1a are located in the same plane to planarize the bonding surface S1.

As shown in FIG. 5, first, the polishing head 10 is moved by the polishing-head moving mechanism 40 such that the pressing member 15 is located above the polishing start position. Next, the pressing member 15 is lowered by the pressing actuator 18 to press the polishing tape 12 against the dielectric film 1b with a predetermined pressing force. Thereafter, the polishing head 10 presses the polishing tape 12 with the predetermined pressing force to polish the dielectric film 1b while being moved in the radial direction of the first substrate W1 by the polishing-head moving mechanism 40. In this embodiment, during polishing of the dielectric film 1b, the polishing head 10 moves in the radially outward direction of the first substrate W1.

During polishing of the dielectric film 1b, the polishing head 10 is moved from the polishing start position to the polishing end position by the polishing-head moving mechanism 40. When the polishing head 10 reaches the polishing end position, the pressing member 15 is raised by the pressing actuator 18, and the polishing of the dielectric film 1b is terminated. A movement speed of the polishing head 10 from the polishing start position to the polishing end position changes according to a predetermined polishing recipe based on the shape of the periphery of the first substrate W1, as described later.

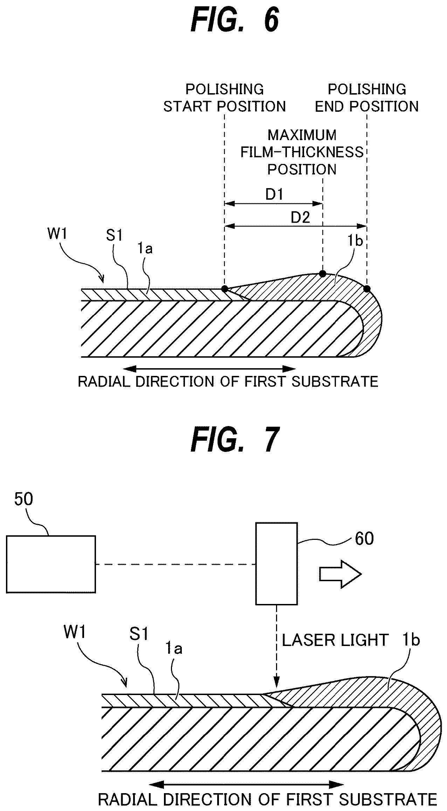

FIG. 6 is a cross-sectional view showing an example of the periphery of the first substrate W1. As shown in FIG. 6, the dielectric film 1b formed on the periphery of the first substrate W1 is raised from the device region 1a, and a thickness of the dielectric film 1b changes from the polishing start position to the polishing end position. In the example of FIG. 6, a maximum film-thickness position, where the thickness of the dielectric film 1b in the bonding surface S1 is largest, is located outward of the polishing start position in the radial direction of the first substrate W1 by a distance D1. The polishing end position is located outward of the polishing start position in the radial direction of the first substrate W1 by a distance D2. The thickness of the dielectric film 1b gradually increases from the polishing start position to the maximum film-thickness position, and slightly steeply decreases from the maximum film-thickness position to the polishing end position.

In order to planarize the bonding surface S1 of the first substrate W1 with high accuracy, it is necessary to polish the dielectric film 1b according to an appropriate polishing recipe corresponding to the shape of the dielectric film 1b. In this embodiment, the polishing recipe includes a change in movement speed of the polishing head 10 from the polishing start position to the polishing end position. A polishing rate in polishing of the dielectric film 1b depends on the movement speed of the polishing head 10. Specifically, the higher the movement speed of the polishing head 10, the lower the polishing rate becomes, and the lower the movement speed of the polishing head 10, the higher the polishing rate. Therefore, the movement speed of the polishing head 10 at a portion where the thickness of the dielectric film 1b is large is set lower than the movement speed of the polishing head 10 at a portion where the thickness of the dielectric film 1b is small, so that the bonding surface S1 of the first substrate W1 can be planarized with high accuracy. In this specification, the portion where the thickness of the dielectric film 1b is large and the portion where the thickness of the dielectric film 1b is small do not mean a portion where the thickness of the dielectric film 1b is larger than a certain numerical value and a portion where the thickness is smaller than a certain numerical value, but mean that the portion where the thickness of the dielectric film 1b is large is thicker than the portion where the thickness of the dielectric film 1b is small.

In this embodiment, the shape of the periphery of the first substrate W1 is measured before polishing of the dielectric film 1b of the first substrate W1. FIG. 7 is a schematic diagram illustrating a manner in which a shape measuring device 60 measures the shape of the periphery of the first substrate W1 before polishing of the dielectric film 1b of the first substrate W1. The shape measuring device 60 is, as an example, a stand-alone type shape measuring device disposed outside the polishing apparatus 100. In another example, the shape measuring device 60 may be a shape measuring device disposed inside the polishing apparatus 100. In this example, when the shape measuring device 60 is disposed inside the polishing apparatus 100, the shape measuring device 60 may be a height measuring device 70 described later.

The shape measuring device 60 is configured to irradiate the periphery of the first substrate W1 with laser light and detect the laser light reflected from the periphery to thereby measure the shape (including dimensions thereof) of the periphery. In one embodiment, the shape of the periphery is measured by scanning the periphery of the first substrate W1 with the laser light while the shape measuring device 60 is moved in the radial direction of the first substrate W1. An example of the shape measuring device 60 is a non-contact type laser displacement sensor, and a commercially available two-dimensional profile measuring device or the like can be used. The shape measuring device 60 is electrically coupled to the operation controller 50, and a measurement result of the shape of the periphery is transmitted to the operation controller 50.

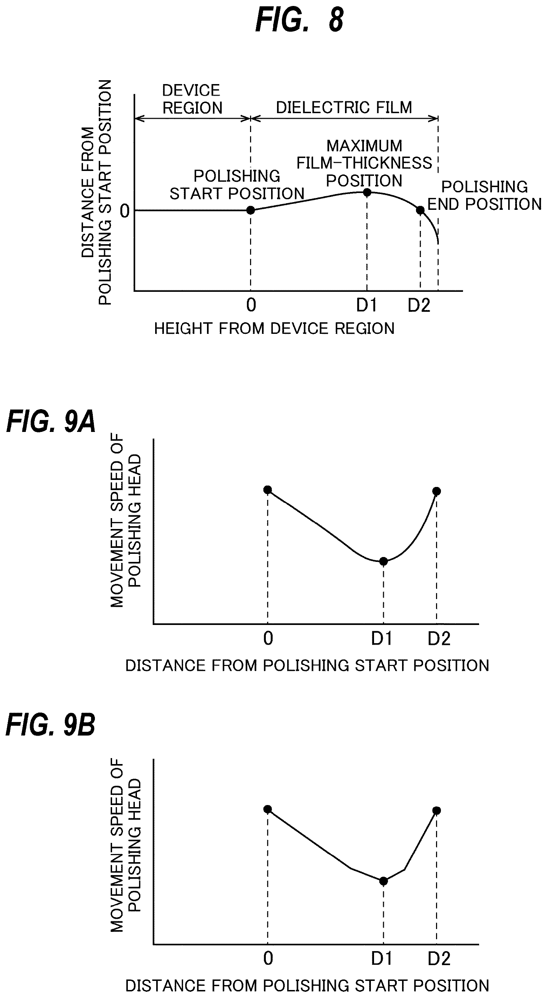

FIG. 8 is a graph showing a result of measuring the shape of the periphery of the first substrate W1 shown in FIG. 6 by the shape measuring device 60. In FIG. 8, horizontal axis represents a distance from the polishing start position, and vertical axis represents a height from the device region 1a. The operation controller 50 determines a polishing target region which is a region of the dielectric film 1b raised from the device region 1a. The polishing target region is a region from the polishing start position to the polishing end position. The operation controller 50 is configured to determine the polishing recipe including the change in the movement speed of the polishing head 10 from the polishing start position to the polishing end position based on the measured shape of the periphery of the first substrate W1.

FIGS. 9A and 9B are graphs each showing an example of the change in the movement speed of the polishing head 10 from the polishing start position to the polishing end position determined by the operation controller 50. In each of FIGS. 9A and 9B, horizontal axis represents the distance from the polishing start position, and vertical axis represents the movement speed of the polishing head 10. The operation controller 50 is configured to determine the polishing recipe such that the movement speed of the polishing head 10 at the portion where the thickness of the dielectric film 1b is large is lower than the movement speed of the polishing head 10 at the portion where the thickness of the dielectric film 1b is small. The movement speed of the polishing head 10 from the polishing start position to the polishing end position is determined such that the surface of the device region 1a and the surface of the dielectric film 1b after polishing are located in the same plane after polishing of the dielectric film 1b.

In the example shown in FIG. 9A, the movement speed of the polishing head 10 from the polishing start position to the polishing end position is inversely proportional to the thickness of the dielectric film 1b from the polishing start position to the polishing end position. The movement speed of the polishing head 10 gradually increases from the polishing start position to the maximum film-thickness position D1, and the movement speed of the polishing head 10 slightly steeply increases from the maximum film-thickness position D1 to the polishing end position D2. In one example, as shown in FIG. 9B, the movement speed of the polishing head 10 from the polishing start position to the polishing end position may change linearly.

The polishing recipe may include a pressing force of the polishing head 10, a rotation speed of the first substrate W1, and the like, in addition to the movement speed of the polishing head 10.

The operation controller 50 is configured to instruct the polishing head 10 and the polishing-head moving mechanism 40 to press the polishing tape 12 against the periphery of the first substrate W1 being rotated while causing the polishing head 10 to be moved according to the determined polishing recipe, thereby polishing the dielectric film 1b formed on the periphery to planarize the bonding surface S1 of the first substrate W1.

The shape of the periphery of the first substrate W1 may vary among individual substrates. In one embodiment, the shape of the periphery of the first substrate W1 is measured by the shape measuring device 60 before polishing of each first substrate W1. The operation controller 50 determines the polishing recipe before polishing of each first substrate W1.

According to this embodiment, the polishing recipe including the movement speed of the polishing head 10 is determined based on the shape of the periphery of the first substrate W1 measured in advance, and the dielectric film 1b formed on the periphery of the first substrate W1 is polished according to the determined polishing recipe. Therefore, since the dielectric film 1b is polished with an appropriate polishing recipe corresponding to the shape of the periphery, flatness of the bonding surface S1 of the laminated substrate Ws can be improved.

In the above-described embodiment, the polishing of the dielectric film 1b of the first substrate W1 is performed while supplying the liquid from the liquid supply nozzle 30 to the bonding surface S1. Polishing performed in the presence of liquid is also called wet polishing. In one embodiment, the polishing of the dielectric film 1b of the first substrate W1 is performed without supplying the liquid to the bonding surface S1. Polishing without using liquid is also called dry polishing. In this case, the polishing apparatus 100 may not include the liquid supply nozzle 30. In the dry polishing, since no liquid is supplied to the bonding surface S1, a temperature of a polishing region of the dielectric film 1b rises due to frictional heat generated between the dielectric film 1b and the polishing surface of the polishing tape 12. In the polishing of the dielectric film 1b using the polishing tape 12 having ceria abrasive grains, when the temperature of the polishing region of the dielectric film 1b rises, a chemical polishing action of the ceria abrasive grains on the dielectric film 1b is enhanced, and the polishing rate can be increased.

In one embodiment, after the polishing of the dielectric film 1b of the first substrate W1, the shape of the periphery of the first substrate W1 may be measured by the above-described shape measuring device 60. When the shape measuring device 60 is a stand-alone type shape measuring device disposed outside the polishing apparatus 100, the shape of the periphery of the first substrate W1 may be measured after the polishing of the dielectric film 1b of the first substrate W1 and after drying of the first substrate W1 by a not-shown drying device. The operation controller 50 is configured to judge necessity of re-polishing of the dielectric film 1b based on the shape of the periphery of the first substrate W1 measured after the polishing of the dielectric film 1b. More specifically, the operation controller 50 judges that the re-polishing of the dielectric film 1b is necessary when a height of the dielectric film 1b after polishing is larger than a height of the surface of the device region 1a.

The operation controller 50 is configured to determine a re-polishing target region which is a portion of the dielectric film 1b having a height larger than the height of the surface of the device region 1a when judging that the re-polishing of the dielectric film 1b is necessary. The re-polishing target region is a region from a re-polishing start position to a re-polishing end position. The operation controller 50 instructs the polishing head 10 and the polishing-head moving mechanism 40 to press the polishing tape 12 against the re-polishing target region of the first substrate W1 being rotated, thereby polishing the re-polishing target region of the dielectric film 1b. In one embodiment, a movement speed of the polishing head 10 from the re-polishing start position to the re-polishing end position may be constant. In another embodiment, the movement speed of the polishing head 10 from the re-polishing start position to the re-polishing end position may be zero. Specifically, the re-polishing target region may be polished without moving the polishing head 10.

In one embodiment, the operation controller 50 is configured to determine a polishing recipe for re-polishing including a change in the movement speed of the polishing head 10 from the re-polishing start position to the re-polishing end position based on the shape of the periphery of the first substrate W1 after polishing. The operation controller 50 instructs the polishing head 10 and the polishing-head moving mechanism 40 to press the polishing tape 12 against the periphery of the first substrate W1 being rotated while causing the polishing head 10 to be moved according to the determined polishing recipe for re-polishing, thereby polishing the re-polishing target region of the dielectric film 1b.

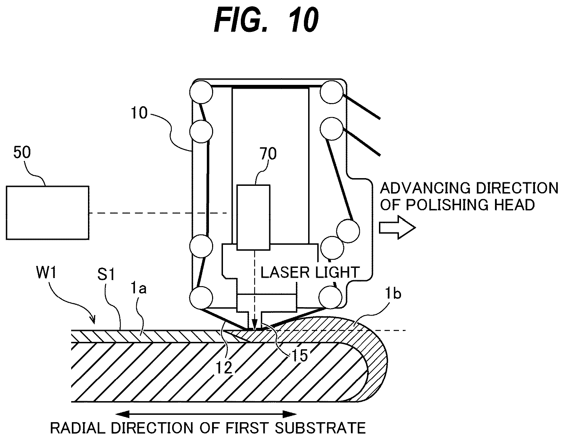

In one embodiment, a height of a polished portion of the dielectric film 1b is measured during the polishing of the dielectric film 1b of the first substrate W1, and the operation controller 50 is configured to limit movement of the polishing head 10 in the radial direction of the first substrate W1 based on the height of the polished portion of the dielectric film 1b. FIG. 10 is a schematic diagram showing an embodiment of a height measuring device 70 configured to measure the height of the polished portion of the dielectric film 1b during the polishing of the dielectric film 1b of the first substrate W1. In this embodiment, the polishing apparatus 100 further includes the height measuring device 70 for measuring the height of the polished portion of the dielectric film 1b during the polishing of the dielectric film 1b of the first substrate W1.

The height measuring device 70 shown in FIG. 10 is attached to the polishing head 10, and is arranged above the pressing member 15 of the polishing head 10. The height measuring device 70 is arranged at the same position as the pressing member 15 of the polishing head 10 in the radial direction of the first substrate W1 held by the substrate holder 5. The height measuring device 70 is located downstream of the polishing head 10 in a rotating direction of the first substrate W1 held by the substrate holder 5. The height measuring device 70 is moved together with the polishing head 10 by the polishing-head moving mechanism 40 during the polishing of the dielectric film 1b of the first substrate W1. The height measuring device 70 arranged at such a position can measure the height of the polished portion of the dielectric film 1b immediately after the dielectric film 1b is polished.

In this embodiment, the height measuring device 70 is configured to irradiate the polished portion of the dielectric film 1b with laser light and detect the laser light reflected from the polished portion of the dielectric film 1b to thereby measure the height of the polished portion of the dielectric film 1b. An example of the height measuring device 70 is a non-contact type distance sensor. However, the specific configuration of the height measuring device 70 is not particularly limited as long as the height measuring device 70 can measure the height of the polished portion of the dielectric film 1b.

The height measuring device 70 is electrically coupled to the operation controller 50, and a measurement value of the height of the polished portion of the dielectric film 1b is transmitted to the operation controller 50. The operation controller 50 is configured to limit the movement of the polishing head 10 in the radial direction of the first substrate W1 based on the height of the polished portion of the dielectric film 1b during the polishing of the dielectric film 1b.

More specifically, when the height of the polished portion of the dielectric film 1b is larger than the height of the surface of the device region 1a, it is necessary to continue polishing of the polished portion of the dielectric film 1b. Therefore, the operation controller 50 instructs the polishing-head moving mechanism 40 to stop the movement of the polishing head 10 in the radial direction of the first substrate W1 until the height of the polished portion of the dielectric film 1b reaches the height of the surface of the device region 1a. After the height of the polished portion of the dielectric film 1b reaches the height of the surface of the device region 1a, the operation controller 50 instructs the polishing-head moving mechanism 40 to move the polishing head 10 in the radial direction at the movement speed included in the polishing recipe. With such an operation, the height of the surface of the dielectric film 1b can be aligned with the height of the surface of the device region 1a.

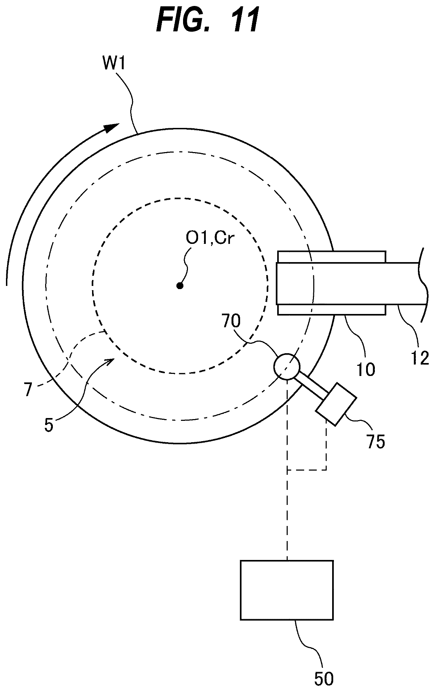

FIG. 11 is a plan view showing another embodiment of the height measuring device 70. Configurations and operations of this embodiment, which will not be particularly described, are the same as those of the embodiment described with reference to FIG. 10, and duplicated descriptions will be omitted. The height measuring device 70 shown in FIG. 11 differs from the embodiment shown in FIG. 10 in that the height measuring device 70 is arranged away from the polishing head 10. The height measuring device 70 is arranged at the same position as the pressing member 15 of the polishing head 10 held by the substrate holder 5 in the radial direction of the first substrate W1. Further, the height measuring device 70 is located downstream of the polishing head 10 in the rotating direction of the first substrate W1 held by the substrate holder 5.

The polishing apparatus 100 further includes a measuring-device moving mechanism 75 configured to move the height measuring device 70 in the radial direction of the first substrate W1 held by the substrate holder 5. The specific configuration of the measuring-device moving mechanism 75 is not particularly limited. The measuring-device moving mechanism 75 is constituted by an electric linear actuator including an electric motor, such as a servomotor or a stepping motor. The measuring-device moving mechanism 75 is configured to be able to control a position of the height measuring device 70 in the radial direction with respect to the first substrate W1 and a movement speed of the height measuring device 70 based on a rotation speed of the electric motor. The measuring-device moving mechanism 75 is electrically coupled to the operation controller 50, and an operation of the measuring-device moving mechanism 75 is controlled by the operation controller 50.

During polishing of the dielectric film 1b of the first substrate W1, the operation controller 50 instructs the measuring-device moving mechanism 75 to move the height measuring device 70 in the radial direction of the first substrate W1 such that the height measuring device 70 is arranged at the same position as the pressing member 15 of the polishing head 10 in the radial direction of the first substrate W1. Specifically, during polishing of the dielectric film 1b of the first substrate W1, the height measuring device 70 is moved along with movement of the polishing head 10. The height measuring device 70 measures a height of a polished portion of the dielectric film 1b during polishing of the dielectric film 1b of the first substrate W1. The operation controller 50 is configured to limit the movement of the polishing head 10 in the radial direction of the first substrate W1 based on the height of the polished portion of the dielectric film 1b during polishing of the dielectric film 1b.

The embodiments described with reference to FIGS. 10 and 11 may be applied to polishing of the dielectric film 1b performed while supplying the liquid from the liquid supply nozzle 30 to the bonding surface S1 (wet polishing), or may be applied to polishing of the dielectric film 1b performed without supplying the liquid to the bonding surface S1 (dry polishing). In the dry polishing, since no liquid is present between the height measuring device 70 and the first substrate W1, the height measuring device 70 can accurately measure the height of the polished portion of the dielectric film 1b.

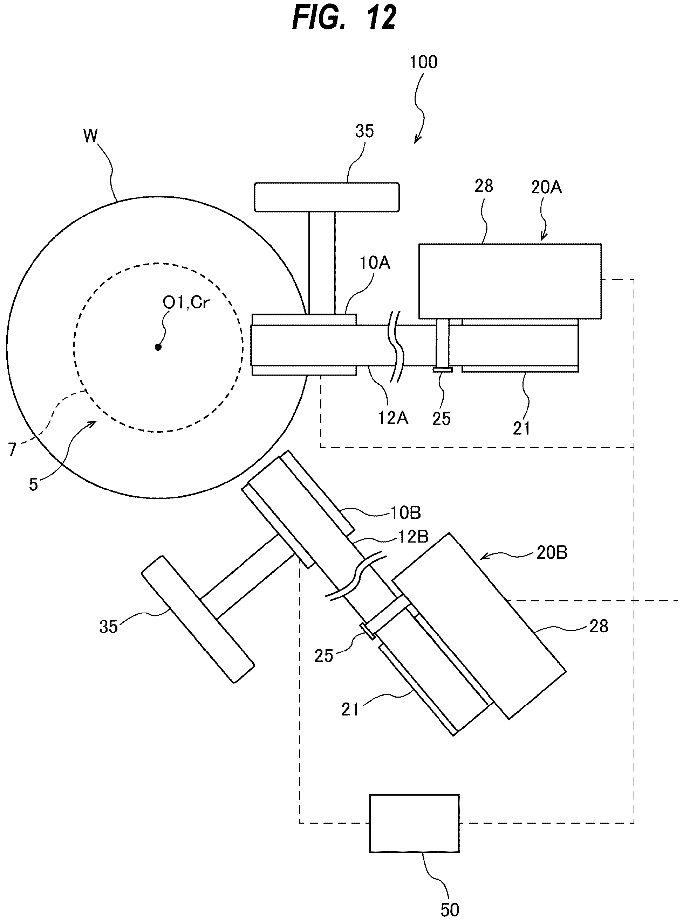

FIG. 12 is a plan view showing another embodiment of the polishing apparatus 100. The polishing apparatus 100 may include a plurality of polishing heads. In the embodiment shown in FIG. 12, the polishing apparatus 100 includes two polishing heads 10A and 10B. Configurations of the polishing heads 10A and 10B are basically the same as the configuration of the polishing head 10 of the above-described embodiment. In one embodiment, the polishing apparatus 100 may include three or more polishing heads.

The polishing head 10A is configured to press a polishing tape 12A as a polishing tool against the periphery of the first substrate W1 to polish the periphery of the first substrate W1. The polishing head 10B is configured to press a polishing tape 12B as a polishing tool against the periphery of the first substrate W1 to polish the periphery of the first substrate W1. The polishing head 10A and the polishing head 10B are arranged along the circumferential direction of the first substrate W1 held by the substrate holder 5.

The polishing apparatus 100 includes two polishing-head moving mechanisms 40 (not shown in FIG. 12) configured to move the polishing head 10A and the polishing head 10B in the radial direction of the first substrate W1 held by the substrate holder 5, respectively. Configurations of the polishing-head moving mechanism 40 configured to move the polishing head 10A and the polishing-head moving mechanism 40 configured to move the polishing head 10B are basically the same as the configuration of the polishing-head moving mechanism 40 of the embodiment described with reference to FIG. 3.

The polishing apparatus 100 of this embodiment includes a polishing-tape feeding mechanism 20A configured to feed the polishing tape 12A to the polishing head 10A and collect the polishing tape 12A from the polishing head 10A, and a polishing-tape feeding mechanism 20B configured to feed the polishing tape 12B to the polishing head 10B and collect the polishing tape 12B from the polishing head 10B. Configurations of the polishing-tape feeding mechanisms 20A and 20B are basically the same as the configuration of the polishing-tape feeding mechanism 20 of the embodiment described with reference to FIG. 3.

The polishing tapes 12A and 12B of this embodiment have ceria (CeO₂) abrasive grains on polishing surfaces thereof. In another embodiment, the polishing tapes 12A and 12B may have other abrasive grains, such as diamond abrasive grains on the polishing surfaces of the polishing tapes 12A and 12B.

In one embodiment, the polishing tool may be whetstones fixed to the pressing members 15 of the polishing heads 10A and 10B, respectively, instead of the polishing tapes 12A and 12B. The whetstones have abrasive grains, such as ceria abrasive grains or diamond abrasive grains, on polishing surfaces of the whetstones.

In this embodiment, the polishing tape 12A supplied to the polishing head 10A has coarse abrasive grains on the polishing surface, and the polishing tape 12B supplied to the polishing head 10B has fine abrasive grains on the polishing surface. In this case, first, the polishing head 10A rough-polishes the dielectric film 1b of the first substrate W1, and the polishing head 10B then finish-polishes the dielectric film 1b of the first substrate W1. Before rough-polishing of the dielectric film 1b of the first substrate W1 by the polishing head 10A, the shape of the periphery of the first substrate W1 is measured by the shape measuring device 60.

The operation controller 50 determines a polishing recipe for rough-polishing including a change in movement speed of the polishing head 10 from a polishing start position to a polishing end position in rough polishing of the dielectric film 1b by the polishing head 10A based on the measured shape of the periphery of the first substrate W1. The operation controller 50 instructs the polishing head 10A and the polishing-head moving mechanism 40 to press the polishing tape 12A against the periphery of the first substrate W1 being rotated while causing the polishing head 10A to be moved according to the determined polishing recipe for rough polishing, thereby rough-polishing the dielectric film 1b formed on the periphery.

Thereafter, the operation controller 50 instructs the polishing head 10B and the polishing-head moving mechanism 40 to press the polishing tape 12B against the periphery of the first substrate W1 being rotated while causing the polishing head 10B to be moved to according to a predetermined polishing recipe for finish-polishing to finish-polish the dielectric film 1b formed on the periphery. In this manner, rough-polishing and finish-polishing of the dielectric film 1b are performed in one polishing apparatus 100, and as a result, the bonding surface S1 of the first substrate W1 can be planarized.

The embodiment described with reference to FIG. 10 or FIG. 11 may be applied to the embodiment described with reference to FIG. 12.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

## Claims

1. A polishing method comprising:
measuring a shape of a periphery of a substrate having a bonding surface for forming a laminated substrate, the bonding surface including a surface of a device region and a surface of a dielectric film formed on the periphery and raised from the device region;
determining a polishing recipe including a change in a movement speed of a polishing head from a polishing start position to a polishing end position based on the measured shape of the periphery;
and polishing the dielectric film to planarize the bonding surface by pressing, by the polishing head, a polishing tool against the periphery of the substrate being rotated while the polishing head is moved in a radial direction of the substrate according to the determined polishing recipe.

2. The polishing method according to claim 1, wherein the movement speed of the polishing head at a portion where a film thickness of the dielectric film is large is lower than the movement speed of the polishing head at a portion where the film thickness of the dielectric film is small.

3. The polishing method according to claim 1, wherein
the polishing tool comprises a polishing tape having abrasive grains, and
the abrasive grains comprise ceria abrasive grains.

4. The polishing method according to claim 3, wherein the polishing of the dielectric film is performed without supplying liquid to the bonding surface.

5. The polishing method according to claim 1, wherein the polishing of the dielectric film is performed while supplying liquid from a liquid supply nozzle to the bonding surface.

6. The polishing method according to claim 1, further comprising:
measuring the shape of the periphery after the polishing of the dielectric film;
judging necessity of re-polishing of the dielectric film based on the measured shape of the periphery after polishing;
determining a re-polishing target region which is a portion of the periphery having a height larger than a height of the surface of the device region when judging that the re-polishing of the dielectric film is necessary; and
polishing the re-polishing target region by pressing, by the polishing head, the polishing tool against the re-polishing target region of the substrate being rotated.

7. The polishing method according to claim 1, further comprising:
measuring a height of a polished portion of the dielectric film by a height measuring device during the polishing of the dielectric film; and
limiting movement of the polishing head based on the height of the polished portion of the dielectric film.

8. The polishing method according to claim 7, wherein the height measuring device is attached to the polishing head.

9. The polishing method according to claim 7, wherein the height measuring device is arranged away from the polishing head, and is arranged at the same position as the polishing head in the radial direction of the substrate.

10. A polishing apparatus comprising:
a substrate holder configured to hold and rotate a substrate having a bonding surface for forming a laminated substrate;
a polishing head configured to press a polishing tool against a periphery of the substrate;
a polishing-head moving mechanism configured to move the polishing head in a radial direction of the substrate held by the substrate holder; and
an operation controller configured to control operations of the polishing head and the polishing-head moving mechanism,
wherein the bonding surface includes a surface of a device region and a surface of a dielectric film formed on the periphery and raised from the device region,
the operation controller is configured to:
determine a polishing recipe including a change in a movement speed of the polishing head from a polishing start position to a polishing end position based on a shape of the periphery measured in advance; and
instruct the polishing head and the polishing-head moving mechanism to press the polishing tool against the periphery of the substrate being rotated while causing the polishing head to be moved according to the determined polishing recipe, thereby polishing the dielectric film to planarize the bonding surface.

11. The polishing apparatus according to claim 10, wherein the movement speed of the polishing head at a portion where a film thickness of the dielectric film is large is lower than the movement speed of the polishing head at a portion where the film thickness of the dielectric film is small.

12. The polishing apparatus according to claim 10, wherein
the polishing tool comprises a polishing tape having abrasive grains, and
the abrasive grains comprise ceria abrasive grains.

13. The polishing apparatus according to claim 12, wherein the polishing apparatus is configured to polish the dielectric film without supplying liquid to the bonding surface.

14. The polishing apparatus according to claim 10, further comprising:
a liquid supply nozzle configured to supply liquid to the bonding surface, wherein
the operation controller is configured to instruct the liquid supply nozzle to supply the liquid to the bonding surface during polishing of the dielectric film.

15. The polishing apparatus according to claim 10, wherein the operation controller is configured to:
judge necessity of re-polishing of the dielectric film based on the shape of the periphery measured after polishing of the dielectric film;
determine a re-polishing target region which is a portion of the periphery having a height larger than a height of the surface of the device region when judging that the re-polishing of the dielectric film is necessary; and
instruct the polishing head to polish the re-polishing target region by causing the polishing head to press the polishing tool against the re-polishing target region of the rotating substrate.

16. The polishing apparatus according to claim 10, further comprising:
a height measuring device configured to measure a height of a polished portion of the dielectric film during polishing of the dielectric film, wherein
the operation controller is configured to limit movement of the polishing head based on the height of the polished portion of the dielectric film.

17. The polishing apparatus according to claim 16, wherein the height measuring device is attached to the polishing head.

18. The polishing apparatus according to claim 16, wherein the height measuring device is arranged away from the polishing head, and is arranged at the same position as the polishing head in the radial direction of the substrate held by the substrate holder.
